# EUROPEAN PATENT APPLICATION

(11) **EP 4 783 226 A1**
(43) Date of publication of application: **29.07.2026**
(21) Application number: 24871937.9
(22) Date of filing: 17.09.2024
(51) Int. Cl.: H01L 21/02, H01L 21/677

(54) **JOINING SYSTEM AND JOINING METHOD**

(30) Priority: 28.09.2023 JP 2023167681
(71) Applicant: Tokyo Electron Limited, Tokyo 107-6325 (JP)
(72) Inventor: YAMASAKI, Yutaka, Koshi-shi, Kumamoto 861-1116 (JP); SAKAMOTO, Ryoichi, Koshi-shi, Kumamoto 861-1116 (JP)
(74) Representative: Manitz Finsterwald Patent- und Rechtsanwaltspartnerschaft mbB
(86) International application number: PCT/JP2024/033011
(87) International publication number: WO 2025/070142

(57) **Abstract**

A bonding system includes a first transfer device 61, a surface modifying apparatus 33, a load lock chamber 31, a transfer chamber 32, a substrate processing apparatus 34, and a bonding apparatus 41. The first transfer device transfers a first substrate W1 and a second substrate W2. The surface modifying apparatus 33 modifies surfaces of the first substrate W1 and the second substrate W2. An interior of the load lock chamber 31 is allowed to be switched between an atmospheric-pressure atmosphere and the reduced-pressure atmosphere. In the transfer chamber 32, a second transfer device 32a transferring the first substrate W1 and the second substrate W2 between the load lock chamber 31 and the surface modifying apparatus 33 is disposed. The surface modifying apparatus 33 includes a first gas supply 122 and a first switching device 126. The first gas supply 122 supplies multiple types of gases into the surface modifying apparatus 33. The first switching device 126 switches a type of gas supplied into the surface modifying apparatus 33. Furthermore, the transfer chamber 32 includes a second gas supply 130 and a second switching device 136. The second gas supply 130 supplies multiple types of gases into the transfer chamber 32. The second switching device 136 switches a type of gas supplied into the transfer chamber 32.

## Description

### TECHNICAL FIELD

The present disclosure relates to a bonding system and a bonding method.

### BACKGROUND

Conventionally, to meet a demand for higher integration of semiconductor devices, the use of three-dimensional integration technology, in which the semiconductor devices are stacked in three dimensions, has been proposed. As an example of a system using this three-dimensional integration technology, there is known a bonding system that bonds substrates such as semiconductor wafers (hereinafter simply referred to as "wafers") together (see, for example, Patent Document 1).

### PRIOR ART DOCUMENT

Patent Document 1: Japanese Patent Laid-open Publication No. 2018-010921

### DISCLOSURE OF THE INVENTION

### PROBLEMS TO BE SOLVED BY THE INVENTION

Exemplary embodiments provide a technique capable of suppressing multiple types of gases from being mixed in a surface modifying apparatus.

### MEANS FOR SOLVING THE PROBLEMS

In an exemplary embodiment, a bonding system includes a first transfer device, a surface modifying apparatus, a load lock chamber, a transfer chamber, a substrate processing apparatus, and a bonding apparatus. The first transfer device transfers a first substrate and a second substrate under a normal-pressure atmosphere. The surface modifying apparatus modifies, under a reduced-pressure atmosphere, surfaces of the first substrate and the second substrate to be bonded to each other. In the load lock chamber, the first substrate and second substrate are transferred between the first transfer device and the surface modifying apparatus, and an interior of the load lock chamber is allowed to be switched between an atmospheric-pressure atmosphere and the reduced-pressure atmosphere. The transfer chamber is disposed adjacent to the load lock chamber. In the transfer chamber, a second transfer device transferring, under the reduced-pressure atmosphere, the first substrate and the second substrate between the load lock chamber and the surface modifying apparatus is disposed. The substrate processing apparatus processes the surfaces of the first substrate and the second substrate modified by the surface modifying apparatus. The bonding apparatus bonds the first substrate and the second substrate processed by the substrate processing apparatus. Further, the surface modifying apparatus includes a first gas supply and a first switching device. The first gas supply supplies multiple types of gases into the surface modifying apparatus. The first switching device switches a type of gas supplied into the surface modifying apparatus. Furthermore, the transfer chamber includes a second gas supply and a second switching device. The second gas supply supplies multiple types of gases into the transfer chamber. The second switching device switches a type of gas supplied into the transfer chamber.

### EFFECT OF THE INVENTION

According to the exemplary embodiment, it is possible to suppress the multiple types of gases from being mixed in the surface modifying apparatus.

### BRIEF DESCRIPTION OF THE DRAWINGS

**FIG. 1** is a schematic plan view illustrating a configuration of a bonding system according to a first exemplary embodiment.
**FIG. 2** is a schematic side view illustrating the configuration of the bonding system according to the first exemplary embodiment.
**FIG. 3** is a schematic side view of a first substrate and a second substrate.
**FIG. 4** is a schematic cross sectional view illustrating a configuration of a surface modifying apparatus.
**FIG. 5** is a schematic plan view schematically illustrating a configuration of a load lock chamber, a transfer chamber, and the surface modifying apparatus according to the first exemplary embodiment.
**FIG. 6** is a flowchart illustrating an example of a transfer processing for an upper wafer performed by the bonding system according to the first exemplary embodiment.
**FIG. 7** is a schematic plan view illustrating a configuration of a load lock chamber, a transfer chamber, and a surface modifying apparatus according to a second exemplary embodiment.
**FIG. 8** is a flowchart illustrating an example of a transfer processing for an upper wafer performed by a bonding system according to the second exemplary embodiment.

### DETAILED DESCRIPTION

Hereinafter, embodiments for a bonding system and a bonding method according to the present disclosure (hereinafter, referred to as "exemplary embodiments") will be described in detail with reference to the accompanying drawings. Further, it should be noted that the present disclosure is not limited by the exemplary embodiments. Furthermore, unless processing contents are contradictory, the various exemplary embodiments can be appropriately combined. In addition, in the various exemplary embodiments to be described below, same parts will be assigned same reference numerals, and redundant description will be omitted

Further, in the following exemplary embodiments, expressions such as "constant," "perpendicular, " "vertical" and "parallel" may be used. These expressions, however, do not imply strictly "constant", "perpendicular, " "vertical" and "parallel". That is, these expressions allow some errors and tolerances in, for example, manufacturing accuracy, installation accuracy, or the like.

Moreover, in the various accompanying drawings, for the purpose of clear understanding, there may be used a rectangular coordinate system in which the X-axis direction, Y-axis direction and Z-axis direction which are orthogonal to one another are defined and the positive Z-axis direction is defined as a vertically upward direction. Further, a rotational direction around a vertical axis may be referred to as "θ direction."

A conventional bonding system includes a surface modifying apparatus that modifies surfaces of the first and second substrates to be bonded to each other in a reduced-pressure atmosphere, and a load lock chamber configured to be switchable between an atmospheric-pressure atmosphere and a reduced-pressure atmosphere. The bonding system also includes a transfer chamber equipped with a transfer device for the surface modifying apparatus, which transfers the first and second substrates between the surface modifying apparatus and the load lock chamber. Further, it is known to perform a surface modification processing in the surface modifying apparatus by using a processing gas.

However, in such a conventional bonding system, when the first or second substrate is carried from the load lock chamber into the surface modifying apparatus via the transfer chamber, a gas supplied into the transfer chamber may enter the surface modifying apparatus. In this case, if the processing gas used for the surface modification processing is different from the gas supplied into the transfer chamber, the multiple types of gases may be mixed inside the surface modifying apparatus.

In this regard, there has been a demand for a technique capable of suppressing the multiple types of gases from being mixed in the surface modifying apparatus.

### (First exemplary embodiment)

### <1. Configuration of bonding system>

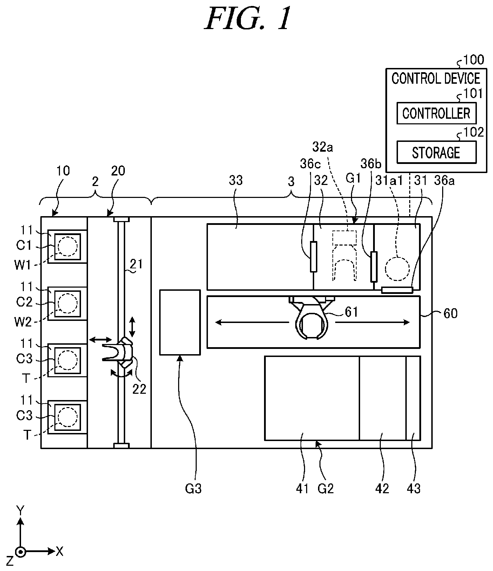

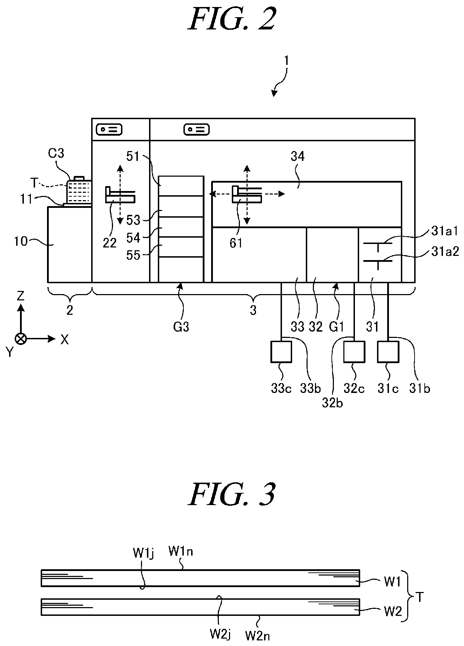

First, a configuration of a bonding system 1 according to a first exemplary embodiment will be described with reference to **FIG. 1** and **FIG. 2****.** **FIG. 1** is a schematic plan view illustrating the configuration of the bonding system 1 according to the first exemplary embodiment, and **FIG. 2** is a schematic side view illustrating the configuration of the bonding system 1 according to the first exemplary embodiment. **FIG. 3** is a schematic side view of a first substrate W1 and a second substrate W2.

The bonding system 1 according to the first exemplary embodiment shown in **FIG. 1** forms a combined substrate T by bonding the first substrate W1 and the second substrate W2 (see **FIG. 3****).**

The first substrate W1 is a semiconductor substrate, such as a silicon wafer or a compound semiconductor wafer, on which multiple electronic circuits are formed. The second substrate W2 is, for example, a bare wafer without any electronic circuit formed thereon. The first substrate W1 and the second substrate W2 have approximately the same diameter.

Alternatively, an electronic circuit may be formed on the second substrate W2. A die (silicon die) may be vacuum-attracted or electrostatically attracted to a surface of the second substrate W2. Further, an insulating layer (e.g., a polyimide film) may be formed between the second substrate W2 and the die. The compound semiconductor wafer mentioned above may include, by way of example, a wafer containing gallium arsenide, silicon carbide, gallium nitride, or indium phosphide, without being limited thereto.

Hereinafter, the first substrate W1 may be referred to as "upper wafer W1," the second substrate W2 as "lower wafer W2," and the combined substrate T as "combined substrate T."

Furthermore, in the following, among plate surfaces of the upper wafer W1, the plate surface to be bonded to the lower wafer W2 will be referred to as "bonding surface W1j, " and the plate surface opposite to the bonding surface W1j will be referred to "non-bonding surface W1n," as shown in **FIG. 3****.** Likewise, among plate surfaces of the lower wafer W2, the plate surface to be bonded to the upper wafer W1 will be referred to as "bonding surface W2j," and the plate surface opposite to the bonding surface W2j will be referred to as "non-bonding surface W2n."

As depicted in **FIG. 1****,** the bonding system 1 is equipped with a carry-in/out station 2 and a processing station 3. The carry-in/out station 2 and the processing station 3 are arranged in this order along the positive X-axis direction. Also, the carry-in/out station 2 and the processing station 3 are connected as a single structure.

The carry-in/out station 2 includes a placement table 10 and a transfer section 20. The placement table 10 is equipped with a multiple number of placement plates 11. Provided on the placement plates 11 are cassettes C1, C2 and C3, each of which accommodates therein a plurality of (*e.g.,* 25 sheets of) substrates horizontally. The cassette C1 accommodates therein upper wafers W1; the cassette C2, lower wafers W2; and the cassettes C3, combined wafers T. In cassette C1 (C2), the upper wafer W1 (lower wafer W2) are stored while being aligned with their bonding surfaces W1j (W2j) facing upward.

The transfer section 20 is provided on the positive X-axis side of the placement table 10 so as to be adjacent thereto. This transfer section 20 is provided with a transfer path 21 extending in the Y-axis direction, and a transfer device 22 configured to be movable along this transfer path 21. The transfer device 22 is also configured to be movable in the X-axis direction as well as in the Y-axis direction and pivotable around the Z-axis, and serves to transfer the upper wafers W1, the lower wafers W2, and the combined wafers T between the cassettes C1 to C3 placed on the placement plates 11 and a third processing block G3 of the processing station 3 to be described later.

Here, the number of the cassettes C1 to C3 placed on the placement plates 11 is not limited to the illustrated example. Furthermore, in addition to the cassettes C1, C2, and C3, a cassette for collecting a defective substrate may be additionally arranged on the placement plate 11.

The processing station 3 is provided with a plurality of, e.g., three processing blocks G1, G2 and G3, each equipped with various types of devices. By way of example, the first processing block G1 is provided on the rear side (positive Y-axis side of **FIG. 1**) of the processing station 3, and the second processing block G2 is provided on the front side (negative Y-axis side of **FIG. 1**) of the processing station 3. Further, the third processing block G3 is provided on the carry-in/out station 2 side (negative X-axis side of **FIG. 1**) of the processing station 3.

A transfer section 60 is formed in an area surrounded by the first to third processing blocks G1 to G3. A transfer device 61 is disposed in the transfer section 60. The transfer device 61 has a transfer arm configured to be movable in a vertical direction and a horizontal direction and pivotable around a vertical axis, for example.

This transfer device 61 moves within the transfer section 60 to transfer the upper wafer W1, the lower wafer W2, and the combined wafer T to devices within the first processing block G1, the second processing block G2, and the third processing block G3 adjacent to the transfer section 60.

Here, the transfer of the upper wafer W1, the lower wafer W2, and the combined substrate T by the transfer device 61 is performed in a normal-pressure atmosphere. As used herein, the term "normal pressure" refers to, for example, an atmospheric pressure, but does not require being exactly identical to the atmospheric pressure, and may include a pressure range of, *e.g.,* ±10 kPa with respect to the atmospheric pressure. The transfer device 61 is an example of a first transfer device.

The first processing block G1 accommodates a load lock chamber 31, a transfer chamber 32, a surface modifying apparatus 33, and a surface hydrophilizing apparatus 34 (see **FIG. 2**).

The load lock chamber 31 is located at a position farthest from the carry-in/out station 2 in the first processing block G1, and is disposed on the positive Y-axis side of the transfer section 60 so to be adjacent thereto with a gate valve 36a therebetween. Further, the transfer chamber 32 is disposed on the negative X-axis side of the load lock chamber 31 so as to be adjacent thereto with a gate valve 36b therebetween. The surface modifying apparatus 33 is located at a position closest to the carry-in/out station 2 in the first processing block G1, and is disposed on the negative X-axis side of the transfer chamber 32 so as to be adjacent thereto with a gate valve 36c therebetween.

In the load lock chamber 31, the upper wafer W1 and the lower wafer W2 are transferred between the transfer device 61 and the surface modifying apparatus 33. To elaborate, multiple transitions 31a1 and 31a2 are provided inside the load lock chamber 31 (see **FIG. 2**). The multiple transitions 31a1 and 31a2 places the upper wafer W1 or the lower wafer W2 thereon. For example, the transition 31a1 places thereon the upper wafer W1 or the lower wafer W2 being transferred from the transfer device 61 to the surface modifying apparatus 33, and the transition 31a2 places thereon the upper wafer W1 or the lower wafer W2 being transferred from the surface modifying apparatus 33 to the transfer device 61.

As shown in **FIG. 2****,** the transitions 31a1 and 31a2 are stacked vertically. However, without being limited thereto, they may be disposed adjacent to each other, when viewed from the top.

A vacuum pump 31c (see **FIG. 2**) is connected to the load lock chamber 31 via a suction line 31b. For example, when the gate valves 36a and 36b are closed and the vacuum pump 31c is operated, the interior of the load lock chamber 31 is decompressed into a reduced-pressure atmosphere. Meanwhile, when the gate valve 36a is opened, for example, the load lock chamber 31 communicates with the transfer section 60, which is under the atmospheric-pressure atmosphere, so that the interior of the load lock chamber 31 is turned into the atmospheric-pressure atmosphere. In this way, the load lock chamber 31 is configured to switch its internal atmosphere between the atmospheric-pressure atmosphere and the reduced-pressure atmosphere.

A transfer device 32a is disposed in the transfer chamber 32. The transfer device 32a has a transfer arm configure to be movable vertically, horizontally, and around a vertical axis, for example. For example, the transfer device 32a receives the upper wafer W1 yet to be modified and placed in the transition 31a1 of the load lock chamber 31, and transfers it to the surface modifying apparatus 33 (hereinafter also referred to as "carrying-in"), or the transfer device 32a transfers the upper wafer W1 already modified in the surface modifying apparatus 33 to the load lock chamber 31 (hereinafter also referred to as "carrying-out") and places it in the transition 31a2 (see **FIG. 2**). The transfer device 32a is an example of a second transfer device.

A vacuum pump 32c (see **FIG. 2**) is connected to the transfer chamber 32 via a suction line 32b. When the vacuum pump 31c is operated, the interior of the transfer chamber 32 is decompressed into a reduced-pressure atmosphere. The gate valve 36b is opened when the load lock chamber 31 is under the reduced-pressure atmosphere. Likewise, the gate valve 36c is opened when the surface modifying apparatus 33 is under the reduced-pressure atmosphere.

With this configuration, the transfer chamber 32 is constantly maintained under the reduced pressure by the vacuum pump 32c. In this way, the transfer device 32a of the transfer chamber 32 is disposed adjacent to load lock chamber 31 and transfers the upper wafer W1 and the lower wafer W2 between the load lock chamber 31 and the surface modifying apparatus 33 under the reduced-pressure atmosphere.

The surface modifying apparatus 33 modifies the bonding surfaces W1j and W2j of the upper and lower wafers W1 and W2. Further, a vacuum pump 33c (see **FIG. 2**) is connected to the surface modifying apparatus 33 via a suction line 33b. When the vacuum pump 33c is operated, the interior of the surface modifying apparatus 33 is decompressed into a reduced-pressure atmosphere. Like the transfer chamber 32, the surface modifying apparatus 33 is also constantly maintained under the reduced-pressure atmosphere.

Therefore, the surface modifying apparatus 33 modifies the bonding surfaces W1j and W2j of the upper and lower wafers W1 and W2 in the reduced-pressure atmosphere. Specifically, the surface modifying apparatus 33 cuts SiO₂ bonds in the bonding surfaces W1j and W2j of the upper and lower wafers W1 and W2 to form single bonds of SiO, thus modifying the bonding surfaces W1j and W2j so that they can be easily hydrophilized afterwards.

Further, in the surface modifying apparatus 33, the processing gas is excited into plasma in the reduced-pressure atmosphere to be ionized. These oxygen ions are then irradiated onto the bonding surfaces W1j and W2j of the upper wafer W1 and the lower wafer W2, thereby plasma-processing the bonding surfaces W1j and W2j to modify them.

Detailed configurations of the load lock chamber 31, the transfer chamber 32, and the surface modifying apparatus 33 configured as described above, and the transfer of the upper wafer W1 through the load lock chamber 31, the transfer chamber 32, and the surface modifying apparatus 33 will be described later.

As shown in **FIG. 1** and **FIG. 2****,** the load lock chamber 31 may be configured so that its internal volume is smaller than the internal volumes of the surface modifying apparatus 33 and the transfer chamber 32. This allows the time required to switch the internal pressure of the load lock chamber 31 to be shorter than the time required to switch the internal pressure of the surface modifying apparatus 33.

Furthermore, as shown in **FIG. 1****,** the transfer device 32a may be disposed adjacent to the load lock chamber 31 rather than inside the load lock chamber 31. This allows the load lock chamber 31 to be scaled down as compared to the case where the transfer device 32a is provided therein, thereby further shortening the time required to switch the internal pressure of the load lock chamber 31.

The surface hydrophilizing apparatus 34 (see **FIG. 2**) hydrophilizes the bonding surfaces W1j and W2j of the upper and lower wafers W1 and W2 by using a hydrophilizing liquid, such as pure water, and cleans the bonding surfaces W1j and W2j. In the surface hydrophilizing apparatus 34, while rotating the upper wafer W1 or the lower wafer W2 held by, for example, a spin chuck, the pure water is supplied onto the upper wafer W1 or the lower wafer W2. As a result, the pure water supplied onto the upper wafer W1 or the lower wafer W2 is diffused on the bonding surface W1j of the upper wafer W1 or the bonding surface W2j of the lower wafer W2, thereby hydrophilizing the bonding surfaces W1j and W2j.

As shown in **FIG. 2****,** the load lock chamber 31, the transfer chamber 32, the surface modifying apparatus 33, and the surface hydrophilizing apparatus 34 are stacked in the first processing block G1. As a specific example, in the first processing block G1, the load lock chamber 31, the transfer chamber 32, and the surface modifying apparatus 33 are located in a lower portion on the negative Z-axis side, while the surface hydrophilizing apparatus 34 is located in an upper portion on the positive side of the Z axis.

In this way, in the first exemplary embodiment, the load lock chamber 31, the transfer chamber 32, and the surface modifying apparatus 33 are disposed below the surface hydrophilizing apparatus 34. With this configuration, the vacuum pumps 31c, 32c, and 33c and the suction lines 31b, 32b, and 33b connected to the load lock chamber 31, the transfer chamber 32, and the surface modifying apparatus 33 can be arranged together in a lower portion of the bonding system 1, so that the overall size of the system can be reduced.

Furthermore, since the vacuum pumps 31c, 32c, and 33c are located near the load lock chamber 31, the transfer chamber 32, and the surface modifying apparatus 33, the lengths of the suction lines 31b, 32b, and 33b can be shortened, thereby minimizing the time required for decompression.

Here, the locations of the load lock chamber 31, the surface modifying apparatus 33, and the surface hydrophilizing apparatus 34 shown in **FIG. 1** are merely examples and are not intended to be limiting. That is, the load lock chamber 31 and the surface modifying apparatus 33 may be located above the surface hydrophilizing apparatus 34. Also, the load lock chamber 31 and the surface modifying apparatus 33 may be located in, for example, the second processing block G2 or the third processing block G3. Besides, a new station may be provided at a position on the positive X-axis side of the processing station 3 or between the carry-in/out station 2 and the processing station 3, for example, and the load lock chamber 31 and the surface modifying apparatus 33 may be disposed in this new station.

The second processing block G2 is equipped with a bonding apparatus 41, a substrate temperature control apparatus 42, and an exhaust port 43. The bonding apparatus 41 is located at the closest position to the carry-in/out station 2 in the second processing block G2. The substrate temperature control apparatus 42 is located on the positive X-axis side of the bonding apparatus 41 so as to be adjacent thereto. The substrate temperature control apparatus 42 is located on the negative X-axis side of the exhaust port 43 so as to be adjacent thereto.

The bonding apparatus 41 bonds the hydrophilized upper and lower wafers W1 and W2 by an intermolecular force.

The substrate temperature control apparatus 42 controls the temperatures of the upper wafer W1 and the lower wafer W2 before being bonded to each other.

The exhaust port 43 exhausts a temperature-controlled gas (hereinafter referred to as "temperature-controlled air"). That is, the processing station 3 is provided with a gas inlet port located at an appropriate position, such as a ceiling of the carry-in/out station 2, for supplying the temperature-controlled air, and the exhaust port 43 exhausts the temperature-controlled air, which has passed through the interior of the processing station 3 after being supplied from the gas inlet port, to the outside of the processing station 3.

Therefore, in the processing station 3, the bonding apparatus 41, the substrate temperature control apparatus 42, and the exhaust port 43 are arranged in this order in the flow direction of the temperature-controlled air (positive X-axis direction). In other words, the substrate temperature control apparatus 42 is disposed downstream of the bonding apparatus 41 in the flow direction of the temperature-controlled air.

Here, the location of the exhaust port 43 is not limited to the illustrated example, and the exhaust port 43 may be located elsewhere, such as near the load lock chamber 31 or the transfer section 60. Further, the location of the gas inlet port is not limited to the illustrated example, and the gas inlet port may be located elsewhere, such as on the floor or wall of the processing station 3.

As shown in **FIG. 2****,** the third processing block G3 is equipped with a position adjusting device 51, transitions 53 and 54, and an inversion transition 55 that are arranged in this order from top to bottom. The locations of the devices in the third processing block G3 are merely examples and are not intended to be limiting.

The bonding system 1 is also equipped with a control device 100. The control device 100 controls the operation of the bonding system 1. The control device 100 is, for example, a computer, and includes a controller 101 and a storage 102. The controller 101 includes a microcomputer having a central processing unit (CPU), a read only memory (ROM), a random access memory (RAM), input/output ports, *etc.,* and various types of circuits. The CPU of the microcomputer reads and executes a program stored in the ROM, thus implementing a control to be described later. Further, the storage 102 is implemented by, for example, a semiconductor memory element such as a RAM or a flash memory, or a storage device such as a hard disk or an optical disk.

The program may have been recorded on a computer-readable recording medium and installed from the recording medium into the storage 102 of the control device 100. The computer-readable recording medium may be, by way of non-limiting example, a hard disk (HD), a flexible disk (FD), a compact disk (CD), a magnetic optical disk (MO), a memory card, or the like.

### <2. Configuration of surface modifying apparatus>

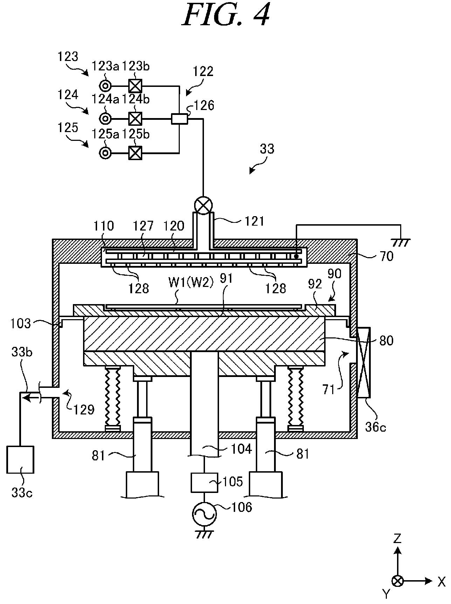

Now, the configuration of the surface modifying apparatus 33 will be described with reference to **FIG. 4. FIG. 4** is a schematic cross-sectional view showing the configuration of the surface modifying apparatus 33.

As illustrated in **FIG. 4****,** the surface modifying apparatus 33 has a processing vessel 70 having a sealable inside. A carry-in/out opening 71 for the upper wafer W1 or the lower wafer W2 is formed at a side surface of the processing vessel 70 on the transfer chamber 32 side (see **FIG.** 1), and a gate valve 36c is provided at the carry-in/out opening 71.

A stage 80 is disposed inside the processing vessel 70. The stage 80 is, for example, a lower electrode, and is made of a conductive material such as, but not limited to, aluminum. A plurality of drivers 81, each equipped with, for example, a motor or the like, are provided below the stage 80. The drivers 81 move the stage 80 up and down.

An exhaust ring 103 with multiple baffle holes is positioned between the stage 80 and an inner wall of the processing vessel 70. The exhaust ring 103 allows an atmosphere inside the processing vessel 70 to be uniformly exhausted from the processing vessel 70.

A conductive power feed rod 104 is connected to a bottom surface of the stage 80. A first high frequency power supply 106 is connected to the power feed rod 104 via a matching device 105 implemented by, for example, a blocking capacitor. During a plasma processing, a high frequency voltage is applied to the stage 80 from the first high frequency power supply 106.

An upper electrode 110 is disposed inside the processing vessel 70. A top surface of the stage 80 and a bottom surface of the upper electrode 110 are arranged parallel to each other, facing each other with a certain distance therebetween. The distance between the top surface of the stage 80 and the bottom surface of the upper electrode 110 is adjusted by the drivers 81.

The upper electrode 110 is grounded and connected to a ground potential. Since the upper electrode 110 is grounded in this manner, damage to the bottom surface of the upper electrode 110 can be suppressed during the plasma processing.

In this manner, the high frequency voltage is applied from the first high frequency power supply 106 to the lower electrode, *i.e.,* the stage 80, generating plasma in the processing vessel 70.

A hollow space 120 is formed inside the upper electrode 110. A gas supply line 121 is connected to this hollow space 120. A first gas supply 122 is connected to the gas supply line 121.

The first gas supply 122 supplies a processing gas into the hollow space 120 of the upper electrode 110 via the gas supply line 121. The processing gas may be, by way of example, an oxygen gas, a nitrogen gas, or an argon gas. The first gas supply 122 includes a nitrogen gas supply 123, an oxygen gas supply 124, an argon gas supply 125, and a first switching device 126.

The nitrogen gas supply 123 includes a nitrogen gas source 123a and a pressure control valve 123b. The nitrogen gas source 123a is, for example, a tank that stores the nitrogen (N₂) gas. The pressure control valve 123b controls the amount of the nitrogen gas supplied into the surface modifying apparatus 33 so that the internal pressure of the surface modifying apparatus 33 is maintained at a preset pressure level.

The oxygen gas supply 124 includes an oxygen gas source 124a and a pressure control valve 124b. The oxygen gas source 124a is, for example, a tank that stores the oxygen (O₂) gas. The pressure control valve 124b controls the amount of the oxygen gas supplied into the surface modifying apparatus 33 so that the internal pressure of the surface modifying apparatus 33 is maintained at a preset pressure level.

The argon gas supply 125 includes an argon gas source 125a and a pressure control valve 125b. The argon gas source 125a is, for example, a tank that stores the argon (Ar) gas. The pressure control valve 125b controls the amount of the argon gas supplied to the surface modifying apparatus 33 so that the internal pressure of the surface modifying apparatus 33 is maintained at a preset pressure level. Here, the pressure control valves 123b, 124b, and 125b may be a common pressure control valve.

The first switching device 126 is provided at a junction point of respective flow paths of the nitrogen gas supplied from the nitrogen gas source 123a, the oxygen gas supplied from the oxygen gas source 124a, and the argon gas supplied from the argon gas source 125a. The first switching device 126 switches the type of gas supplied to the upper electrode 110. Specifically, the controller 101 may control the first switching device 126 to selectively switch the type of gas supplied to the upper electrode 110 into the nitrogen gas, the oxygen gas, or the argon gas. By way of example, when the controller 101 controls the first switching device 126 to switch the type of gas supplied to the upper electrode 110 into the nitrogen gas, the nitrogen gas supplied from the nitrogen gas source 123a is introduced into the hollow space 120 of the upper electrode 110 via the first switching device 126 and the gas supply line 121, with its supply amount controlled by the pressure control valve 123b.

Likewise, when the controller 101 controls the first switching device 126 to switch the type of gas supplied to the upper electrode 110 into the oxygen gas, the oxygen gas supplied from the oxygen gas source 124a is introduced into the hollow space 120 of the upper electrode 110 via the first switching device 126 and the gas supply line 121, with its supply amount controlled by the pressure control valve 124b.

Likewise, when the controller 101 controls the first switching device 126 to switch the type of gas supplied to the upper electrode 110 into the argon gas, the argon gas supplied from the argon gas source 125a is introduced into the hollow space 120 of the upper electrode 110 via the first switching device 126 and the gas supply line 121, with its supply amount controlled by the pressure control valve 125b. In this way, the first gas supply 122 is configured to supply multiple types of gases into the surface modifying apparatus 33.

A baffle plate 127 is provided in the hollow space 120 to promote uniform diffusion of the processing gas and a charge elimination gas. The baffle plate 127 is provided with multiple small holes. A multiple number of gas outlets 128 are formed in a bottom surface of the upper electrode 110 to discharge the processing gas and the charge elimination gas from the hollow space 120 into the processing vessel 70.

The processing vessel 70 has a suction port 129. Connected to this suction port 129 is a suction line 33b, which communicates with the vacuum pump 33c configured to evacuate the processing vessel 70 to a preset vacuum level.

In the surface modifying apparatus 33 configured as described above, a surface modification processing is performed by using one of the multiple types of processing gases.

Here, in a conventional bonding system, there is known a technique of supplying a gas into a transfer chamber to regulate the internal pressure of the transfer chamber. However, when the upper wafer W1 or the lower wafer W2 is carried from the load lock chamber 31 into the surface modifying apparatus 33 via the transfer chamber 32, the gas supplied into the transfer chamber 32 may enter the surface modifying apparatus 33. If a gas different from the gas supplied into the transfer chamber 32 is used as a processing gas for the surface modification processing, multiple types of gases may be mixed inside the surface modifying apparatus 33 due to the gas entering the surface modifying apparatus 33 from the transfer chamber 32. In such a case, the gas needs to be removed from the surface modifying apparatus 33 before performing the surface modification processing, which may result in a longer processing time.

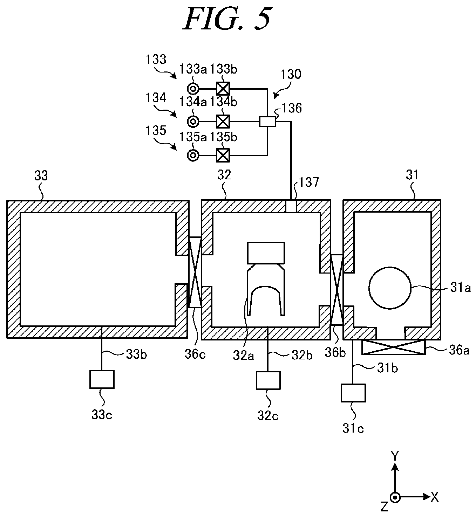

In view of the foregoing, the bonding system 1 according to the first exemplary embodiment is configured such that the same types of gases as the multiple types of gases supplied to the surface modifying apparatus 33 can be supplied into the transfer chamber 32. With this configuration, when the upper wafer W1 and the lower wafer W2 are carried in, the same type of gas as the processing gas used for the surface modification processing in the surface modifying apparatus 33 can be supplied into the transfer chamber 32. This suppresses the multiple types of gases from being mixed in the surface modifying apparatus 33 during this carrying-in operation. Hereinafter, a configuration of a gas supply that supplies a gas into the transfer chamber 32 will be described with reference to **FIG. 5****.**

**FIG. 5** is a schematic plan view showing the configuration of the load lock chamber 31, the transfer chamber 32, and the surface modifying apparatus 33 according to the first exemplary embodiment.

As depicted in **FIG.** 5, the transfer chamber 32 is equipped with a second gas supply 130. The second gas supply 130 supplies a gas into the transfer chamber 32. The gas supplied into the transfer chamber 32 is used, for example, to regulate the internal pressure of the transfer chamber 32. The gas supplied into the transfer chamber 32 is the same type of gas as the processing gas supplied into the surface modifying apparatus 33. For example, the gas supplied to the transfer chamber 32 is an oxygen gas, a nitrogen gas, and an argon gas, and the second gas supply 130 includes a nitrogen gas supply 133, an oxygen gas supply 134, an argon gas supply 135, a second switching device 136, and a supply port 137.

The nitrogen gas supply 133 includes a nitrogen gas source 133a and a pressure control valve 133b. The nitrogen gas source 133a is, for example, a tank that stores the nitrogen (N₂) gas. The nitrogen gas source 133a may be the same supply source as the nitrogen gas source 123a. The pressure control valve 133b controls the amount of the nitrogen gas supplied to the transfer chamber 32 so that the internal pressure of the transfer chamber 32 is maintained at a preset pressure level.

The oxygen gas supply 134 includes an oxygen gas source 134a and a pressure control valve 134b. The oxygen gas source 134a is, for example, a tank that stores the oxygen (O₂) gas. The oxygen gas source 134a may be the same supply source as the oxygen gas source 124a. The pressure control valve 134b controls the amount of the oxygen gas supplied to the transfer chamber 32 so that the internal pressure of the transfer chamber 32 is maintained at a preset pressure level.

The argon gas supply 135 includes an argon gas source 135a and a pressure control valve 135b. The argon gas source 135a is, for example, a tank that stores the argon (Ar) gas. The argon gas source 135a may be the same supply source as the argon gas source 125a. The pressure control valve 135b controls the amount of the argon gas supplied to the transfer chamber 32 so that the internal pressure of the transfer chamber 32 is maintained at a preset pressure. Here, the pressure control valves 133b, 134b, and 135b may be a common pressure control valve.

The second switching device 136 is provided at a junction point of respective flow paths of the nitrogen gas supplied from the nitrogen gas source 133a, the oxygen gas supplied from the oxygen gas source 134a, and the argon gas supplied from the argon gas source 135a. The second switching device 136 switches the type of gas supplied into the transfer chamber 32. Specifically, the controller 101 may control the second switching device 136 to selectively switch the type of gas supplied into the transfer chamber 32 into the nitrogen gas, the oxygen gas, or the argon gas. For example, when the controller 101 controls the second switching device 136 to switch the type of gas supplied into the transfer chamber 32 into the nitrogen gas, the nitrogen gas supplied from the nitrogen gas source 133a is introduced into the transfer chamber 32 from the supply port 137 via the second switching device 136, with its supply amount controlled by the pressure control valve 133b.

Likewise, when the controller 101 controls the second switching device 136 to switch the type of gas supplied into the transfer chamber 32 into the oxygen gas, the oxygen gas supplied from the oxygen gas source 134a is introduced into the transfer chamber 32 from the supply port 137 via the second switching device 136, with its supply amount controlled by the pressure control valve 134b.

Likewise, when the controller 101 controls the second switching device 136 to switch the gas type supplied into the transfer chamber 32 into the argon gas, the argon gas supplied from the argon gas source 135a is introduced into the transfer chamber 32 from the supply port 137 via the second switching device 136, with its supply amount controlled by the pressure control valve 134b. In this way, the second gas supply 130 is configured to supply multiple types of gases into the transfer chamber 32.

This configuration allows the same type of processing gas used in the surface modification processing of the surface modifying apparatus 33 to be supplied into the transfer chamber 32 when the upper wafer W1 and the lower wafer W2 are carried in. Therefore, it is possible to suppress multiple types of gases from being mixed in the surface modifying apparatus 33 during this carrying-in operation.

While the example described here illustrates the first switching device 126 and the second switching device 136 being provided at the branching point of the multiple gas flow paths to switch the type of gas supplied to the transfer chamber 32 and the surface modifying apparatus 33, the present exemplary embodiment is not limited thereto. By way of example, the first switching device 126 may include three opening/closing valves: an opening/closing valve provided in the flow path of the nitrogen gas supplied from the nitrogen gas source 123a, an opening/closing valve provided in the flow path of the oxygen gas supplied from the oxygen gas source 124a, and an opening/closing valve provided in the flow path of the argon gas supplied from the argon gas source 125a. The same applies to the second switching device 136.

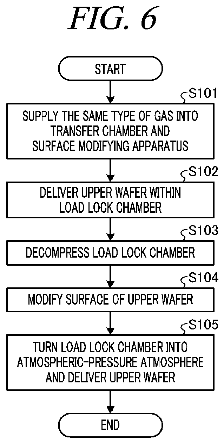

Now, the transfer of the upper wafer W1 through the load lock chamber 31, the transfer chamber 32, and the surface modifying apparatus 33 according to the first exemplary embodiment will be described with reference to **FIG. 6. FIG. 6** is a flowchart illustrating an example of a transfer processing for the upper wafer W1 performed by the bonding system 1 according to the first exemplary embodiment. Further, since the transfer of the lower wafer W2 is identical to the transfer of the upper wafer W1, the following description generally applies to the transfer of the lower wafer W2. Various processes shown in **FIG. 6** are performed under the control of the controller 101. Furthermore, it is assumed that the gate valves 36a, 36b, and 36c are all closed before the start of the processes shown in **FIG. 6****.**

First, the same type of gas is supplied from the first gas supply 122 and the second gas supply 130 into the transfer chamber 32 and the surface modifying apparatus 33 (process S101). Specifically, based on recipe information stored in the storage 102 indicating a sequence of the surface modification processing performed by the surface modifying apparatus 33, the controller 101 controls the second switching device 136 to switch the gas supplied from the second gas supply 130 into the transfer chamber into the same type of gas as the gas supplied into the surface modifying apparatus 33, thereby supplying the same type of gas into the transfer chamber 32 and the surface modifying apparatus 33.

Next, the cassette C1 accommodating the plurality of upper wafers W1, the cassette C2 accommodating the plurality of lower wafers W2, and the empty cassette C3 are placed on the preset placement plates 11 of the carry-in/out station 2. The transfer device 22 then takes out the upper wafer W1 from the cassette C1 and transfers it to the transition 53 of the third processing block G3 of the processing station 3.

Thereafter, the upper wafer W1 before being modified is transferred by the transfer device 61 to the load lock chamber 31 of the first processing block G1. Then, the gate valve 36a is opened, and the upper wafer W1 is placed in the transition 31a1 of the load lock chamber 31 (process S102). Here, when the upper wafer W1 before being modified is placed in the transition 31a1, an upper wafer W1 or a lower wafer W2 that has already been modified in a previous processing may be placed in the transition 31a2. In such a case, after placing the unmodified upper wafer W1 in the transition 31a1, the transfer device 61 may receive the modified upper or lower wafer W1 or W2 from the transition 31a2 and carry it from the load lock chamber 31.

Next, after the gate valve 36a is closed, the vacuum pump 31c is operated to decompress the load lock chamber 31, thereby creating a reduced-pressure atmosphere therein (process S103).

Subsequently, the gate valves 36b and 36c are opened, and the upper wafer W1 is transferred from the load lock chamber 31 to the surface modifying apparatus 33 by the transfer device 32a in the transfer chamber 32. Then, the gate valves 36b and 36c are closed, and in the surface modifying apparatus 33, the processing gas is excited into plasma to be ionized under the reduced-pressure atmosphere. These oxygen ions are irradiated onto the bonding surface W1j of the upper wafer W1, so that the bonding surface W1j is plasma-processed. As a result, the bonding surface W1j of the upper wafer W1 is modified (process S104).

Upon the completion of the surface modification processing, the gate valves 36b and 36c are opened, and the upper wafer W1 is transferred from the surface modifying apparatus 33 to the load lock chamber 31 by the transfer device 32a to be placed in the transition 31a2. Then, after the gate valves 36b and 36c are closed, a non-illustrated air release valve disposed in the load lock chamber 31 is opened, switching the atmosphere in the load lock chamber 31 from the reduced-pressure atmosphere to the atmospheric-pressure atmosphere (process S105). While the load lock chamber 31 is turned into the atmospheric-pressure atmosphere as described above, the transfer chamber 32 and the surface modifying apparatus 33 remain in the reduced-pressure atmosphere. The transfer device 61 then takes out the modified upper wafer W1 from the transition 31a2 of the load lock chamber 31 and transfers it to the surface hydrophilizing apparatus 34, where the next processing is to be performed.

As described above, when carrying the upper wafer or the lower wafer from the load lock chamber 31 into the surface modifying apparatus 33 via the transfer chamber 32, the first gas supply 122 and the second gas supply 130 supply the same type of gas among the multiple types of gases into the surface modifying apparatus 33 and the transfer chamber 32, respectively. As a specific example, the controller 101 controls the second switching device 136 based on the recipe information stored in the storage 102, which indicates the sequence of the surface modification processing performed by the surface modifying apparatus 33, to switch the gas supplied from the second gas supply 130 into the transfer chamber to the same type of gas as the gas supplied into the surface modifying apparatus 33.

This suppresses the multiple types of gases from being mixed in the surface modifying apparatus 33 when the upper wafer W1 or the lower wafer W2 is carried in.

Further, in the first exemplary embodiment, a user may manually perform the process S103. On the other hand, by having the controller 101 automatically perform the processing of the process S103, it is possible to suppress the multiple types of gases from being mixed in the surface modifying apparatus 33 even when the user is away from the bonding system 1.

As stated above, the bonding system 1 according to the first exemplary embodiment is configured to supply the multiple types of gases into the transfer chamber 32. This allows the same type of gas as the processing gas used for the surface modification processing in the surface modifying apparatus 33 to be supplied into the transfer chamber 32 when the upper wafer W1 and the lower wafer W2 are carried in. Therefore, mixture of the multiple types of gases in the surface modifying apparatus 33 during the carrying-in operation may be suppressed.

### (Second exemplary embodiment)

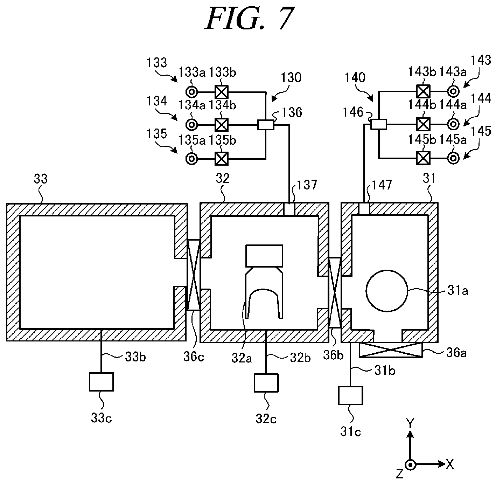

**FIG.** 7 is a schematic plan view illustrating a configuration of a load lock chamber 31, a transfer chamber 32, and a surface modifying apparatus 33 according to a second exemplary embodiment. The first exemplary embodiment has been described for the example where the transfer chamber 32 includes the second gas supply 130 capable of supplying multiple types of gases into the transfer chamber 32. However, the load lock chamber 31 may also include a gas supply capable of supplying multiple types of gases into the load lock chamber 31.

Specifically, as shown in **FIG. 7****,** the load lock chamber 31 includes a third gas supply 140. The third gas supply 140 supplies a gas into the load lock chamber 31. The gas supplied into the load lock chamber 31 is used, for example, to cool the interior of the load lock chamber 31. Further, the gas may be used to cool the interior of the load lock chamber 31. The gas supplied into the load lock chamber 31 is the same type of gas as a processing gas supplied into the surface modifying apparatus 33, such as an oxygen gas, a nitrogen gas, or an argon gas. The third gas supply 140 includes a nitrogen gas supply 143, an oxygen gas supply 144, an argon gas supply 145, a third switching device 146, and a supply port 147.

The nitrogen gas supply 143 includes a nitrogen gas source 143a and a pressure control valve 143b. The nitrogen gas source 143a is, for example, a tank that stores the nitrogen (N₂) gas. The nitrogen gas source 143a may be the same supply source as the nitrogen gas source 123a. The pressure control valve 143b controls the amount of the nitrogen gas supplied into the load lock chamber 31 so that the internal pressure of the load lock chamber 31 is maintained at a preset pressure level.

The oxygen gas supply 144 includes an oxygen gas source 144a and a pressure control valve 144b. The oxygen gas source 144a is, for example, a tank that stores the oxygen (O₂) gas. The oxygen gas source 144a may be the same supply source as the oxygen gas source 124a. The pressure control valve 144b controls the amount of the oxygen gas supplied into the load lock chamber 31 so that the internal pressure of the load lock chamber 31 is maintained at a preset pressure level.

The argon gas supply 145 includes an argon gas source 145a and a pressure control valve 145b. The argon gas source 145a is, for example, a tank that stores the argon (Ar) gas. The argon gas source 145a may be the same supply source as the argon gas source 125a. The pressure control valve 145b controls the amount of the argon gas supplied into the load lock chamber 31 so that the internal pressure of the load lock chamber 31 is maintained at a predetermined pressure. Here, the pressure control valves 143b, 144b, and 145b may be a common pressure control valve.

The third switching device 146 is provided at a junction point of respective flow paths of the nitrogen gas supplied from the nitrogen gas source 143a, the oxygen gas supplied from the oxygen gas source 144a, and the argon gas supplied from the argon gas source 145a. The third switching device 146 switches the type of gas supplied into the load lock chamber 31. Specifically, the controller 101 controls the third switching device 146 to selectively switch the type of gas supplied into the load lock chamber 31 into the nitrogen gas, the oxygen gas, or the argon gas. By way of example, when the controller 101 controls the third switching device 146 to switch the type of gas supplied into the load lock chamber 31 into the nitrogen gas, the nitrogen gas supplied from the nitrogen gas source 143a is introduced into the load lock chamber 31 from the supply port 147 via the third switching device 146, with its supply amount controlled by the pressure control valve 143b.

Likewise, when the controller 101 controls the third switching device 146 to switch the type of gas supplied into the load lock chamber 31 into the oxygen gas, the oxygen gas supplied from the oxygen gas source 144a is introduced into the load lock chamber 31 from the supply port 147 via the third switching device 146, with its supply amount controlled by the pressure control valve 144b.

Likewise, when the controller 101 controls the third switching device 146 to switch the type of gas supplied into the load lock chamber 31 into the argon gas, the argon gas supplied from the argon gas source 145a is introduced into the load lock chamber 31 from the supply port 147 via the third switching device 146, with its supply amount controlled by the pressure control valve 145b. In this way, the third gas supply 140 is configured to be able to supply the multiple types of gases into the load lock chamber 31.

This configuration allows the same type of gas as used for the surface modification processing in the surface modifying apparatus 33 to be supplied to the load lock chamber 31 when the upper wafer W1 and the lower wafer W2 are carried in. Therefore, the multiple gases may be further suppressed from being mixed in the surface modifying apparatus 33 during the carrying-in operation.

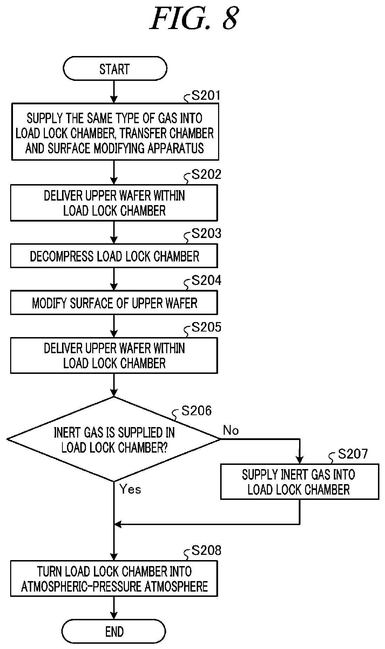

Now, a transfer of the upper wafer W1 through the load lock chamber 31, the transfer chamber 32, and the surface modifying apparatus 33 according to the second exemplary embodiment will be described with reference to **FIG. 8. FIG. 8** is a flowchart illustrating an example of a transfer processing for the upper wafer W1 performed by the bonding system 1 according to the second exemplary embodiment. Here, since a transfer of the lower wafer W2 is identical to the transfer of the upper wafer W1, the following description generally also applies to the transfer of the lower wafer W2. Various processes shown in **FIG. 8** are performed under the control of the controller 101. It is assumed that the gate valves 36a, 36b, and 36c are all closed before the start of the processes shown in **FIG. 8****.**

First, the same type of gas is supplied from the first gas supply 122, the second gas supply 130, and the third gas supply 140 into the load lock chamber 31, the transfer chamber 32, and the surface modifying apparatus 33 (process S201). Specifically, based on the recipe information stored in the storage 102 indicating the sequence of the surface modification processing performed by the surface modifying apparatus 33, the controller 101 controls the second switching device 136 to switch the gas supplied from the second gas supply 130 into the transfer chamber 32 into the same type of gas as the gas supplied into the surface modifying apparatus 33. Likewise, the controller 101 controls the third switching device 146 to switch the gas supplied from the third gas supply 140 into the load lock chamber 31 into the same type of gas as the gas supplied into the surface modifying apparatus 33. As a result, the same type of gas is supplied into the load lock chamber 31, the transfer chamber 32, and the surface modifying apparatus 33.

Next, the upper wafer W1 before being modified is transferred by the transfer device 61 into the load lock chamber 31 of the first processing block G1, where the same processes as the processes 5102, S103, and S104 are performed (processes S202, S203, and S204).

Upon the completion of the surface modification processing, the gate valves 36b and 36c are opened, and the upper wafer W1 is transferred by the transfer device 32a from the surface modifying apparatus 33 into the load lock chamber 31 to be placed in the transition 31a2 (process S205).

Then, after the gate valves 36b and 36c are closed, a determination is made as to whether the gas supplied into the load lock chamber 31 during the carrying-in (process S203) of the upper wafer W1 (process S203) is an inert gas such as a nitrogen gas or an argon gas (process S206). If the gas supplied to the load lock chamber 31 is the inert gas (process S206, Yes), the controller 101 proceeds to the next processing (process S208). On the other hand, if the gas supplied to the load lock chamber 31 is a gas other than the inert gas, *i.e.,* an active gas (process S206, No), the controller 101 controls the third switching device 146 to switch the gas supplied from the third gas supply 140 into the inert gas (process S207).

Thereafter, by opening a non-illustrate air release valve provided in the load lock chamber 31, the atmosphere inside the load lock chamber 31 is switched from the reduced-pressure atmosphere to the atmospheric-pressure atmosphere (process S208). Theen, the transfer device 61 takes out the modified upper wafer W1 from the transition 31a2 of the load lock chamber 31 and transfers it to the surface hydrophilizing apparatus 34 where the next processing is to be performed.

As described above, based on the recipe information stored in the storage 102 indicating the sequence of the surface modification processing performed by the surface modifying apparatus 33, the controller 101 controls the second switching device 136 to switch the gas supplied from the second gas supply 130 into the transfer chamber 32 to the same gas as the gas supplied into the surface modifying apparatus 33, and controls the third switching device 146 to switch the gas supplied from the third gas supply 140 to the same gas as the gas supplied into the load lock chamber 31. This makes it possible to further suppress the mixture of the multiple types of gases in the surface modifying apparatus 33 when the upper wafer W1 or the lower wafer W2 is carried in.

Furthermore, if, among the multiple types of gases, a gas other than the inert gas is supplied into the surface modifying apparatus 33, the transfer chamber 32, and the load lock chamber 31 when the upper wafer W1 or the lower wafer W2 is carried in, the controller 101 controls the third switching device 146 to supply the inert gas into the load lock chamber 31 when the upper wafer W1 or the lower wafer W2 is transferred from the surface modifying apparatus 33 to the load lock chamber 31 via the transfer chamber 32. As a result, in a subsequent processing, when the gate valve 36a is opened to bring the load lock chamber 31 into the atmospheric-pressure atmosphere, it is possible to reduce the likelihood that the concentration of the active gas within the load lock chamber 31 increases.

It should be noted that the above-described exemplary embodiment is illustrative in all aspects and is not anyway limiting. In fact, the above-described exemplary embodiment can be embodied in various forms. The above-described exemplary embodiment may be omitted, replaced and modified in various ways without departing from the scope and the spirit of claims.

Furthermore, the following configuration examples are also within the technical scope of the present disclosure.
(1) A bonding system including:
   a first transfer device transferring a first substrate and a second substrate under a normal-pressure atmosphere;
   a surface modifying apparatus modifying, under a reduced-pressure atmosphere, surfaces of the first substrate and the second substrate to be bonded to each other;
   a load lock chamber in which the first substrate and the second substrate are transferred between the first transfer device and the surface modifying apparatus, an interior of the load lock chamber being allowed to be switched between an atmospheric-pressure atmosphere and the reduced-pressure atmosphere;
   a transfer chamber disposed adjacent to the load lock chamber and in which a second transfer device transferring, under the reduced-pressure atmosphere, the first substrate and the second substrate between the load lock chamber and the surface modifying apparatus is disposed;
   a surface hydrophilizing apparatus hydrophilizing the surfaces of the first substrate and the second substrate modified by the surface modifying apparatus; and
   a bonding apparatus bonding the first substrate and the second substrate hydrophilized by the surface hydrophilizing apparatus,
   wherein the surface modifying apparatus includes:
      a first gas supply supplying multiple types of gases into the surface modifying apparatus; and
      a first switching device switching a type of gas supplied into the surface modifying apparatus, and
      the transfer chamber includes:
         a second gas supply supplying multiple types of gases into the transfer chamber; and
         a second switching device switching a type of gas supplied into the transfer chamber.
(2) The bonding system of (1),
   wherein when the first substrate or the second substrate is carried from the load lock chamber into the surface modifying apparatus via the transfer chamber, a same type of gas among the multiple types of gases is supplied into the surface modifying apparatus and the transfer chamber from the first gas supply and the second gas supply, respectively.
(3) The bonding system of (1), further including:
   a controller controlling, based on recipe information indicating a sequence of a surface modification processing performed by the surface modifying apparatus, the second switching device to switch the gas supplied into the transfer chamber from the second gas supply into a same type of gas as the gas supplied into the surface modifying apparatus.
(4) The bonding system of (1) or (2),
   wherein the load lock chamber includes:
   a third gas supply supplying multiple types of gases into the load lock chamber; and
   a third switching device switching a type of gas supplied into the transfer chamber.
(5) The bonding system of (4), further including:
   a controller controlling, based on recipe information indicating a sequence of a surface modification processing performed by the surface modifying apparatus, the second switching device to switch the gas supplied into the transfer chamber from the second gas supply into a same type of gas as the gas supplied into the surface modifying apparatus, and controlling the third switching device to switch the gas supplied into the load lock chamber from the third gas supply into the same type of gas as the gas supplied into the surface modifying apparatus.
(6) The bonding system of (5),
   wherein when the first substrate or the second substrate is carried from the load lock chamber into the surface modifying apparatus via the transfer chamber in a state where a gas other than an inert gas among the multiple types of gases is supplied into the surface modifying apparatus, the transfer chamber, and the load lock chamber, the controller controls the third switching device such that, when the first substrate or the second substrate is carried out from the surface modifying apparatus into the load lock chamber via the transfer chamber, the inert gas is supplied into the load lock chamber.
(7) A bonding method performed in the bonding system as described in (1), including:
   carrying the first substrate or the second substrate from the load lock chamber into the surface modifying apparatus via the transfer chamber; and
   supplying a same type of gas among the multiple types of gases into the surface modifying apparatus and the transfer chamber from the first gas supply and the second gas supply, respectively.

### EXPLANATION OF CODES

1: Bonding system
31: Load lock chamber
32: Transfer chamber
32a: Transfer device
33: Surface modifying apparatus
34: Surface hydrophilizing apparatus
41: Bonding apparatus
61: Transfer device
100: Control device
101: Controller
102: Storage
122: First gas supply
126: First switching device
130: Second gas supply
136: Second switching device
140: Third gas supply
146: Third switching device

## Claims

1. A bonding system comprising:
a first transfer device transferring a first substrate and a second substrate under a normal-pressure atmosphere;
a surface modifying apparatus modifying, under a reduced-pressure atmosphere, surfaces of the first substrate and the second substrate to be bonded to each other;
a load lock chamber in which the first substrate and the second substrate are transferred between the first transfer device and the surface modifying apparatus, an interior of the load lock chamber being allowed to be switched between an atmospheric-pressure atmosphere and the reduced-pressure atmosphere;
a transfer chamber disposed adjacent to the load lock chamber and in which a second transfer device transferring, under the reduced-pressure atmosphere, the first substrate and the second substrate between the load lock chamber and the surface modifying apparatus is disposed;
a surface hydrophilizing apparatus hydrophilizing the surfaces of the first substrate and the second substrate modified by the surface modifying apparatus; and
a bonding apparatus bonding the first substrate and the second substrate hydrophilized by the surface hydrophilizing apparatus,
wherein the surface modifying apparatus comprises:
a first gas supply supplying multiple types of gases into the surface modifying apparatus; and
a first switching device switching a type of gas supplied into the surface modifying apparatus, and
the transfer chamber comprises:
a second gas supply supplying multiple types of gases into the transfer chamber; and
a second switching device switching a type of gas supplied into the transfer chamber.

2. The bonding system of Claim 1,
wherein when the first substrate or the second substrate is carried from the load lock chamber into the surface modifying apparatus via the transfer chamber, a same type of gas among the multiple types of gases is supplied into the surface modifying apparatus and the transfer chamber from the first gas supply and the second gas supply, respectively.

3. The bonding system of Claim 1, further comprising:
a controller controlling, based on recipe information indicating a sequence of a surface modification processing performed by the surface modifying apparatus, the second switching device to switch the gas supplied into the transfer chamber from the second gas supply into a same type of gas as the gas supplied into the surface modifying apparatus.

4. The bonding system of Claim 1,
wherein the load lock chamber comprises:
a third gas supply supplying multiple types of gases into the load lock chamber; and
a third switching device switching a type of gas supplied into the transfer chamber.

5. The bonding system of Claim 4, further comprising:
a controller controlling, based on recipe information indicating a sequence of a surface modification processing performed by the surface modifying apparatus, the second switching device to switch the gas supplied into the transfer chamber from the second gas supply into a same type of gas as the gas supplied into the surface modifying apparatus, and controlling the third switching device to switch the gas supplied into the load lock chamber from the third gas supply into the same type of gas as the gas supplied into the surface modifying apparatus.

6. The bonding system of Claim 5,
wherein when the first substrate or the second substrate is carried from the load lock chamber into the surface modifying apparatus via the transfer chamber in a state where a gas other than an inert gas among the multiple types of gases is supplied into the surface modifying apparatus, the transfer chamber, and the load lock chamber, the controller controls the third switching device such that, when the first substrate or the second substrate is carried out from the surface modifying apparatus into the load lock chamber via the transfer chamber, the inert gas is supplied into the load lock chamber.

7. A bonding method performed in the bonding system as claimed in Claim 1, comprising:
carrying the first substrate or the second substrate from the load lock chamber into the surface modifying apparatus via the transfer chamber; and
supplying a same type of gas among the multiple types of gases into the surface modifying apparatus and the transfer chamber from the first gas supply and the second gas supply, respectively.
